(19) Europäisches Patentamt
European Patent Office
Office européen des brevets

(11) **EP 2 723 071 A1**

(12) **EUROPEAN PATENT APPLICATION**

(43) Date of publication:
**23.04.2014 Bulletin 2014/17**

(51) Int Cl.:
***H04N 7/24*** *(2011.01)*

(21) Application number: **13003859.9**

(22) Date of filing: **02.08.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **22.10.2012 GB 201218942**

(71) Applicant: **Gurulogic Microsystems OY**
**20100 Turku (FI)**

(72) Inventors:
• **Karkkainen, Tuomas**
**20230 Turku (FI)**
• **Kalevo, Ossi**
**37800 Toijala (FI)**

(74) Representative: **Norris, Timothy Sweyn et al**
**BasckIPR Ltd.**
**9 Meadowford**
**Newport**
**Saffron Walden**
**Essex CB11 3QL (GB)**

(54) **Encoder, decoder and method**

(57)     An encoder (10) encodes data (20, D1) to generate corresponding encoded data (70, E2). The encoder (10) includes an analysis unit (100) for analysing one or more portions (40) of the data (20, D1) to be encoded, and for directing the one or more portions (40) to appropriate one or more encoding units (110), wherein the one or more encoding units (110) are operable to encode the one or more portions (40) thereat to generate the encoded data (70, E2). The one or more encoding units (110) are operable to employ mutually different encoding algorithms when encoding the one or more portions (40). At least one encoding unit (110(*i*)) of the one or more encoding units (110) is operable to compute data values present in each portion (40) received thereat, to sub-divide the data values into at least two sets, to compute at least one aggregate value for a given set derived from the data values present in the given set. Whilst retaining a spatial mask (320) of the portion (40), the spatial mask (320) and information representative of the values computed for the at least two data sets is included in the encoded data (70, E2). A corresponding decoder (25) for decoding data (70) generated by the encoder (10) executes an inverse of encoding steps employed in the encoder (10). The encoder (10) and/or the decoder (25) are beneficially implemented using dedicated electronic hardware, for example a custom digital integrated circuit, a field-programmable gate array (*FPGA*) or similar. Alternatively, or additionally, the encoder (10) and/or the decoder (25) can be implemented by executing one or more software products, stored on non-transitory machine-readable data storage media, on computing hardware coupled in data communication with data memory. Optionally, the computing hardware is implemented as a high-speed reduced-instruction-set (RISC) processor.

FIG. 2A

**Description**

**Technical Field**

The present disclosure relates to encoders for encoding data (D1) corresponding to a variety of content, for example still images, video content, graphics content, audio content, measurement data and so forth, for generating corresponding encoded data (E2). Moreover, the present disclosure concerns methods of encoding data (D1) corresponding to a variety of content, for example still images, video content, graphics content, audio content, measurement data and so forth, for generating corresponding encoded data (E2). Furthermore, the present disclosure relates to decoders for decoding data (E2) in an encoded format generated by the aforesaid encoders. Additionally, the present disclosure is concerned with methods of decoding data (E2) generated by aforesaid encoders. Yet additionally, the present disclosure relates to software products recorded on non-transitory machine-readable data storage media, wherein the software products are executable upon computing hardware for implementing aforementioned methods.

**Background**

There are many contemporary known methods of encoding data (D1) to generate encoded data (E2), and also decoding the encoded data (E2) to generate decoded data (D3). Nevertheless, there is a lack of a method of encoding data which is suitable for a broad range of content represented by the data (D1) to be encoded, for example still images, video content, audio content or graphics data. Such encoding has as its primary aim to generate encoded data (E2) that is more compact than corresponding data (D1) to be encoded. Moreover, there is also a lack of a corresponding decoder for decoding such encoded data (E2).

Image encoding methods such as *JPEG* ("Joint Photographic Experts Group", namely lossy DCT-based coding, wherein "DCT" is an abbreviation for Discrete Cosine Transform), *JPEG2000* ("Joint Photographic Experts Group", namely wavelet-based encoding) and *WebP* (image format encoding which employs both lossy and lossless compression during encoding) are known to be well adapted for compressing natural image content, but are less suitable for compressing text or images whose colours are described by only a few colour values and whose content has a relatively high spatial frequency component. An alternative known method of encoding data is referred to as *GIF* ("Graphics Interchange Format") and employs a palette-based compression algorithm which is well adapted to encode images that can be presented with a relatively small number of colour values required to render the images, for example 256 colour values; however, if the images to be encoded by *GIF* algorithms include natural objects having subtle spatially-gradual colour variations, *GIF* creates undesirable artefacts which are noticeable in corresponding decoded *GIF* images. Known contemporary *PNG* encoding ("Portable Networks Graphics", lossless encoding) is generally similar to *GIF* encoding and provides more options for encoding image data, but is not nevertheless well adapted for images which contain a small range of colour values. Other known encoding methods employ text encoding using OCR ("Optical Character Recognition") in combination with encoding characters; OCR is sometimes an appropriate method to employ, but is sensitive to positioning of text within an image, tilting of the text within the image, a font of the text and also an object in which the text is located; additionally, OCR can potentially require considerable processing power for its implementation.

More recently, scientific publications have proposed yet alternative encoding methods which are suitable for encoding data that is in a bi-level block data sequence format; details of these scientific publications are provided in Table 1.

Table 1: Encoding methods for encoding data in a bi-level block data sequence format.

| Title of publication | Authors | Publication details |
|---|---|---|
|  |  |  |
| "A bi-level block coding technique for encoding data sequences with sparse distribution" | Li Tan and Jean Jiang | Proceedings of the 2008 IAJC-IJME International Conference, International Journal of Modern Engineering (IJME), paper 185, ENT 201. ISBN 978-1-60643-379-9 |
| "Lossless compression of waveform data for efficient transmission and storage" | S.D. Stearms, L. Tan, and N. Magotra | IEEE Transactions on Geoscience and Remote Sensing, Vol. 31, no. 3, pp 645-654, May 1993 |
| "A block coding technique for encoding sparse binary patterns" | G. Zeng and N. Ahmed | IEEE Transactions on Acoustics, Speech and Signal Processing, Vol. 37, no. 5, pp 778-780, May 1989 |

Aforesaid known methods of encoding data, and corresponding known methods of decoding such encoded data, are not well adapted for a broad range of content represented by the data, despite the known methods employing a wide range of mutually different approaches. Despite considerable research over many years to evolve more efficient encoding algorithms to provide improved data compression, namely an issue of great importance to communication systems handling streamed video content, an optimal encoding method has yet to be devised.

In a United States patent US 6, 151, 409 *("Methods for Compressing and Reconstructing a Color Image in a Computer System"*; Applicant - National Science Council, Taipei, Taiwan), there is disclosed a method of compressing a colour image, namely by employing visual block pattern truncation coding (VBPIC), in which conventional block truncation coding (BTC) serves to encode an original image. The method defines an edge block according to human visual perception. In an event that a difference between two quantized values of BTC in a block is larger than a threshold value which is defined by visual characteristics, the block will be identified as an edge block. In an edge block, the bitmap is adapted to compute block gradient orientation and to match the block pattern.

The method is only barely suitable for an image that contains only 4 x 4 blocks which further contain either a DC level or a clear edge at an angle of 90° or 45°. Moreover, the method is capable of removing noise, or is capable of removing details when the mask does not hit the target exactly. Furthermore, the method is not at all suitable for coding text or texture, and is not suitable for coding patterns that cannot be expressed with a straight line, or that have a different direction from multiples of 45°.

In a published United States patent US 5, 668, 932 ("Digital Video Data Compressions Technique", Applicant - Microsoft Corporation), there is described an alternative technique for compressing digital video data that provides improved compression relative to conventional block compression techniques. In the alternative technique, image data is broken down into cells and iteratively compressed. The cells are compressed using compression formats that are most appropriate for the contents of the cells. A determination is first made whether or not a cell is substantially identical to a succeeding cell in a previous frame. If the cell is substantially identical to the cell in the previous frame, the cell is encoded in compressed form as a duplicate of the previous cell. Moreover, solid-colour compression approaches and eight-colour compression approaches may be integrated into the compression technique.

Thus, the method uses a bit mask which conveys whether a given pixel being processed belongs to a higher value, namely brighter pixels, or to a lower value, namely dimmer pixels, for each block, cell or sub-block. Moreover, the method attempts to encode entire images.

In a published PCT application WO 00/19374 ("Compressing and Decompression Image Data with 4-level Block Coding", Applicant - Silicon Graphics Inc.), there is described a method and an apparatus for compressing and uncompressing image data. Optionally, the method of compressing a colour cell comprises steps of:

(i) defining at least four luminance levels of the colour cells;
(ii) generating a bitmask for the colour cells, wherein the bitmask has a plurality of entries each corresponding to a respective one of the pixels, and each of the entries for storing data identifying one or the luminance levels associated with a corresponding one of the pixels;
(iii) calculating a first average colour of pixels associated with a first one of the luminance levels;
(iv) calculating a second average colour of pixels associated with a second one of the luminance levels; and
(v) storing the bitmask in association with the first average colour and the second average colour.

Optionally, the colour cell includes a matrix of 4 x 4 pixels, the bitmask includes 32-bits, and each of the colour values include 16-bits, such that a compression rate of 4-bits per pixel is achievable. The method is applicable to compress texture data, such that the texture data is capable of being more efficiently cached and moved during texture mapping; compression of luminance, intensity and alpha textures are also possible to be achieved.

Moreover, aforementioned known coding methods have various shortcomings which makes them unsuitable for a wide spectrum of types of data.

Summary

The present disclosure seeks to provide an improved method of encoding data (D1) to generate corresponding encoded data (E2), for example encoded data (E2) which is compressed relative to its corresponding unencoded data (D1).

Moreover, the present invention also seeks to provide an encoder which employs an improved method of encoding data (D1) to generate corresponding encoded data (E2), for example encoded data (e2) which is compressed relative to its corresponding unencoded data (D1).

Furthermore, the present invention seeks to provide an improved method of decoding data (E2) generated from encoders pursuant to the present invention.

Additionally, the present invention seeks to provide an improved decoder for decoding data (E2) generated from encoders pursuant to the present invention.

According to a first aspect, there is provided an encoder as claimed in appended claim 1: there is provided an encoder for encoding data (D1) to generate corresponding encoded data (E2), characterized in that the encoder includes an analysis unit for analysing one or more portions of the data (D1) to be encoded and directing the one or more portions to appropriate one or more encoding units, wherein the one or more encoding units are operable to encode the one or more portions thereat to generate the encoded data (E2), wherein:

the one or more encoding units are operable to employ mutually different encoding algorithms when encoding the one or more portions;

at least one encoding unit of the one or more encoding units is operable to compute data values present in each portion received thereat, to subdivide the data values into at least two sets, to compute at least one aggregate value for a given set derived from the data values present in the given set, and whilst retaining a spatial mask of the portion, and wherein the spatial mask and information representative of the values computed for the at least two data sets are included in the encoded data (E2).

The present invention is of advantage in that the encoder is operable to compute aggregate values of sets and masks defining layouts of portions of the data (D1) to be encoded for inclusion in encoded data (E2) from the encoder which provides for efficient encoding of certain types of content present in the data (D1) to be encoded.

Optionally, the encoder includes an output encoder unit for receiving encoded output data from the one or more encoding units and for further encoding this encoded output data to generate the encoded data (E2) from the encoder.

Optionally, the encoder further includes an input stage for sub-dividing and/or combining the data (D1) to be encoded to generate the one or more portions when the data (D1) to be encoded is not already included in the one or more portions.

Optionally, in the encoder, the at least one encoding unit of the one or more encoding units is operable to subdivide the data values present in each portion into a range of 2 to 8 data sets, or 2 or more data sets. For example, 8 data sets are optionally used for 8-bit binary data.

Optionally, the encoder is operable to store information representative of the one or more masks of the one or more portions in a remote database for access by one or more decoders when decoding the encoded data (E2) generated by the encoder.

Optionally, in the encoder, the at least one aggregate value is an arithmetic average, a skewed average, a logarithmic average, a weighted average, a mean value, a minimum value, a maximum value, a modal value, or a median value. Other types of computation are also possible, for example, a computed result of a complex mathematical function, for example a polynomial computation that provides a form of aggregated result.

According to a second aspect, there is provided a method of encoding data (D1) to generate corresponding encoded data (E2), characterized in that the method includes:

(a) using an analysis unit for analysing one or more portions of the data (D1) to be encoded and directing the one or more portions to appropriate one or more encoding units, wherein the one or more encoding units are operable to encode the one or more portions thereat to generate the encoded data (E2), wherein the one or more encoding units are operable to employ mutually different encoding algorithms when encoding the one or more portions; and

(b) using at least one encoding unit of the one or more encoding units to compute data values present in each portion received thereat, to subdivide the data values into at least two sets, to compute at least one aggregate value for a given set derived from the data values present in the given set, and whilst retaining a spatial mask of the portion, wherein the spatial mask and information representative of the values computed for the at least two data sets are included in the encoded data (E2).

Optionally, the method includes using an output encoder unit for receiving encoded output data from the one or more encoding units and for further encoding this encoded output data to generate the encoded data (E2).

Optionally, the method includes using at least one encoding unit of the one or more encoding units to subdivide the data values present in each portion into a range of 2 to 8 data sets, or 2 or more data sets.

Optionally, the method includes storing information representative the one or more masks of the one or more portions in a remote database for access by one or more decoders when decoding the encoded data (E2).

Optionally, in the method, the encoded data (E2) is further encoded and/or compressed. More optionally, in the method, the further encoding and/or compression includes at least one of: DPCM (*"differential pulse-code modulation"*), RLE (*"run-length encoding"*), SRLE, EM (Entropy Modifier), arithmetic encoding, delta coding, ODelta coding, VLC ("*Variable-Length Coding*"), Lempel-Ziv coding (ZLIB, LZO, LZSS, LZ77), Burrow-Wheeler transform-based coding (RLE, BZIP2), Huffman coding.

According to a third aspect, there is provided a decoder for decoding encoded data (E2) to generate corresponding decoded data (D3), characterized in that the decoder includes

an analysis unit for analysing one or more portions of the encoded data (E2) and directing the one or more portions to appropriate one or more decoding units, wherein the one or more decoding units are operable to decode the one or more portions thereat for generating the decoded data (D3), wherein

at least one of the one or more decoding units is operable to extract a spatial mask and information representative of aggregate values for at least two data sets included in the encoded data (E2), and for assigning values to elements in the mask pursuant to which of the sets the elements belong as defined by the mask.

Optionally, the decoder includes an output decoder unit for receiving decoded output data from the one or more decoding units and for further combining these decoded output data to generate the total decoded data (D3) from the decoder.

Optionally, the decoder further includes an input stage for extracting from the encoded data (E2) one or more portions for directing as defined by encoding parameters present in the encoded data to one or more decoding units.

Optionally, in the decoder, the at least one of the one or more decoding units is operable to assign values to elements of the mask corresponding to the data sets, wherein there are in a range of 2 to 8 data sets, or 2 or more data sets. For example, 8 data sets are optionally used for 8-bit binary data.

Optionally, the decoder is operable to retrieve information representative the one or more masks of the one or more portions from a remote database when decoding the encoded data (E2) generated by an encoder.

Optionally, the decoder is implemented such that the aggregate value is at least one of: an arithmetic average, a skewed average, a logarithmic average, a weighted average, a mean value, a minimum value, a maximum value, a modal value, or a median value. Other types of computation are also possible, for example, a computed result of a complex mathematical function, for example a polynomial computation which provides a form of aggregated result.

According to a fourth aspect, there is provided a method of decoding encoded data (E2) to generate corresponding decoded data (D3), characterized in that the method includes:

(a) using an analysis unit for analysing one or more portions of the encoded data (E2) and directing the one or more portions to appropriate one or more decoding units, wherein the one or more decoding units are operable to decode the one or more portions thereat for generating the decoded data (D3); and

(b) using at least one decoding unit of the one or more decoding units to extract a spatial mask and information representative of aggregate values computed for at least two data sets included in the encoded data (E2), and to assign values to elements in the mask pursuant to which of the sets the elements belong as defined by the mask.

Optionally, the method includes using an output decoder unit for receiving decoded data from the one or more decoding units and for further combining these decoded output data to generate the total decoded data (D3).

Optionally, the method further includes using an input stage for extracting from the encoded data (E2) one or more portions for directing as defined by encoding parameters present in the encoded data (E2) to one or more decoding units.

Optionally, in the method, the at least one decoding unit of the one or more decoding units is operable to assign values to elements of the mask corresponding the data sets, wherein there are in a range of 2 to 8 data sets, or 2 or more data sets. Such an example is beneficially used for 8-bit binary data, although further 16-bit, 32-bit and so forth binary data is optionally used.

Optionally, the method includes retrieving information representative the one or more masks of the one or more portions from a remote database when decoding the encoded data (E2) generated by an encoder.

Optionally, when using the method, the at least one aggregate value is at least one of: an arithmetic average, a skewed average, a logarithmic average, a weighted average, a mean value, a minimum value, a maximum value, a modal value, or a median value. Other types of computation are also possible, for example, a computed result of a complex mathematical function, for example a polynomial computation that provides a form of aggregated result.

According to a fifth aspect, there is provided a data communication system including at least one encoder pursuant to the first aspect for encoding data (D1) and generating corresponding encoded data (E2), and including at least one decoder pursuant to the third aspect for decoding the encoded data (E2) to generate decoded data (D3).

According to a sixth aspect, there is provided a method of communicating data in a data communication system pursuant to the sixth aspect, wherein the method of communicating data utilizes a combination of a method pursuant to the second aspect, and a method pursuant to the fourth aspect.

According to a seventh aspect, there is provided a software product recorded on non-transitory machine-readable data storage media, characterized in that the software product is executable upon computing hardware for executing a method pursuant to the second aspect.

According to an eighth aspect, there is provided a software product recorded on non-transitory machine-readable data storage media, characterized in that the software product is executable upon computing hardware for executing a method pursuant to the fourth aspect.

It will be appreciated that features of the invention are susceptible to being combined in various combinations without departing from the scope of the invention as defined by the appended claims.

**Description of the diagrams**

Embodiments of the disclosure will now be described, by way of example only, with reference to the following diagrams wherein:

FIG. 1 is an illustration of an encoder and a decoder;
FIG. 2A is a schematic illustration of an encoder for implementing a method of encoding data;
FIG. 2B is a schematic illustration of a decoder for implementing a method of decoding data (E2) that has been encoded pursuant to the present disclosure;
FIG. 3 is a schematic illustration of a second encoding stage of the encoder of FIG. 2A;
FIG. 4 is an illustration of subdividing image data into data blocks, namely portions, for encoding in the second encoding stage of the encoder of FIG. 2A;
FIG. 5 is an illustration of a data block to be encoded using the encoder of FIG. 2A;
FIG. 6 is an illustration of a mask for the data block of FIG. 5, after computation of aggregate values for sets of levels employed to represent the data block of FIG. 5; and
FIG. 7 is an illustration of a regenerated decoded data block derived from encoded data generated by the encoder of FIG. 2A.

In the accompanying diagrams, an underlined number is employed to represent an item over which the underlined number is positioned or an item to which the underlined number is adjacent. A non-underlined number relates to an item identified by a line linking the non-underlined number to the item. When a number is non-underlined and accompanied by an associated arrow, the non-underlined number is used to identify a general item at which the arrow is pointing.

**Description of embodiments**

In overview, the present disclosure is concerned with an improved method of encoding data (D1) to generate corresponding encoded data (E2), wherein the method is capable of providing an enhanced degree of coding efficiency. The improved method is capable of efficiently coding a wide range of content represented in the data (D1) to be encoded, for example still images, video content, graphics content, audio content, *ECG* ("electrocardiogram"), seismic data and so forth.

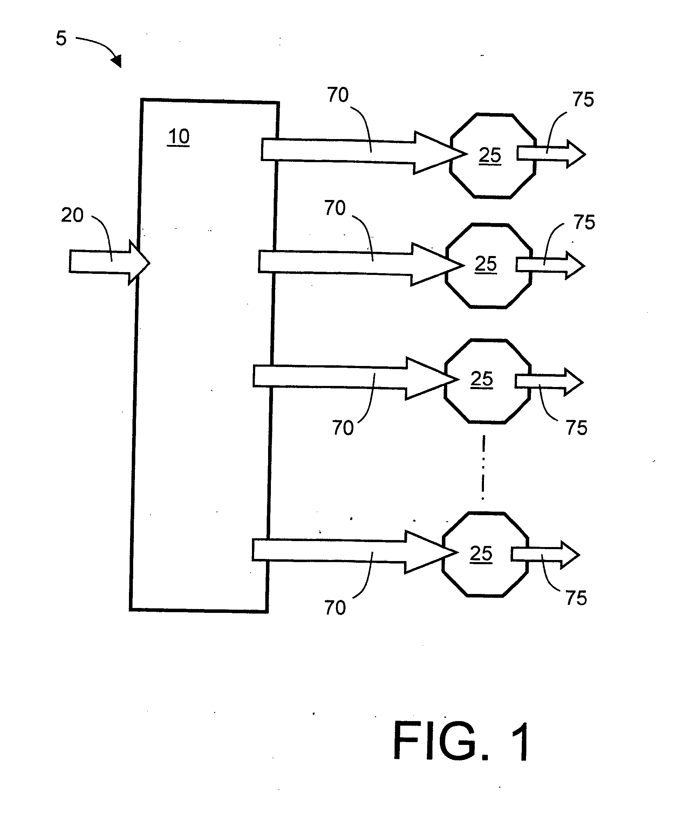

Referring to FIG. 1, there is provided an illustration of an encoder **10** which is operable to encode data **20** (D1) using a method pursuant to the present disclosure. The encoder **10** generates encoded data **70** (E2) which can be stored and/or streamed for subsequent decoding at one or more decoders **25**. The one or more decoders **25** are operable to generate corresponding decoded data **75** (D3) for consumption by one or more users. The decoded data **75** (D3) optionally corresponds substantially to the unencoded data **20** (D1). A combination of at least one encoder **10** and at least one corresponding decoder **25** forms a data communication system indicated generally by **5,** namely a codec arrangement.

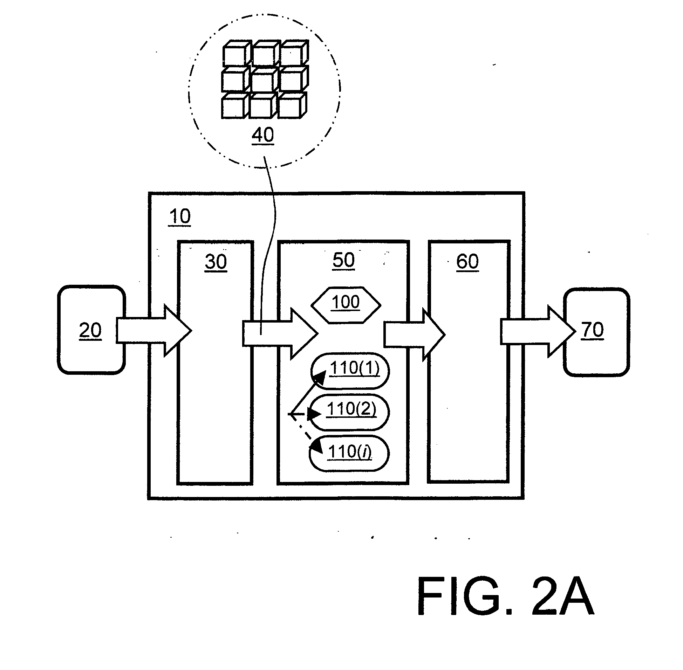

Referring to FIG. 2A, there is provided an illustration of the encoder **10** which is operable to encode the data **20** (D1) using a method pursuant to the present disclosure. The encoder **10** employs a first stage **30** which partitions the data **20** (D1) to be encoded into data blocks **40,** if the data **20** (D1) is not already in a data block format; such partitioning of the data **20** (D1) to be encoded optionally results in the data blocks **40** being of mutually different size, namely non-uniform, depending upon a nature of data content included within the data blocks **40**; this is distinguished from many known encoding algorithms which employ a uniform partitioning of data (D1) into corresponding data blocks. In a second stage **50,** the encoder **10** includes a plurality of encoding units **100** which employ various types of encoding algorithm, wherein the encoding algorithms are mutually different, and some of the encoding algorithms can be known algorithms, for example DCT but not limited thereto, wherein the encoding units **110(1)** to **110(n)** are used selectively to process each data block **40**. At least one of the encoding units **110(1)** to **110(n)** is operable to sort data present in its data block **40** into at least two levels as well as generating a mask describing which data values in the data block **40** belong to which corresponding level, as well as computing values of the data sorted into each level, for example an average value, a mean value or similar. The mask is beneficially implemented as a spatial bit map. A third stage **60** involves compressing the bitmap as well as the mean values for each level to generate encoded data **70** (E2) from the encoder **10;** different compression algorithms are optionally employed for the third stage **60,** for example *RLE* ("Run-length encoding"), *DPCM* ("Differential pulse-code modulation"), *VLC* ("Variable-length coding"), SRLE, EM (Entropy Modifier), ODelta coding, Range Coding, although other data compression algorithms are alternatively or additionally employed, for example multi-stage data compression. Optionally, the encoder **10** can be employed in combination with other encoders for achieving hybrid encoding of the data **20** (D1) to generate encoded data **70** (E2), for example *DCT, palette, DPCM.* In practice, the term "level" can correspond to one or more of: a chrominance level, a luminance level, a colour value, a brightness, an amplitude, a frequency, an intensity; however, "level" can also include other parameters describing physical variables depending upon a nature of the data **20** (D1) to be encoded.

In the first stage **30,** the data blocks **40** can vary in size, depending upon a nature of content present in the data **20** (D1) to be encoded. The data 20 (D1) is optionally 1-dimensional, for example audio content, *ECG-data (Electrocardiography)*, seismic data. Alternatively, the data **20** (D1) is multi-dimensional, for example still images, video content, graphics content, 3D image/video/graphics. Moreover, 2-dimensional input data includes, for example, square, triangle, circle, and similar elements, namely optionally any form of 2-dimensional geometrical shape. Furthermore, 3-dimensional image data includes, for example, elements which are cubic, pyramid, cylinder, ball-shaped, and so forth. When the data **20** (D1) to be encoded includes spatially high frequency components and only a few levels to define spatial elements represented in the data **20** (D1), contemporary known encoding methods are especially ineffective, but are processed efficiently in the encoder **10.** Optionally, the encoder **10** is capable of encoding the data **20** (D1) as original data or formed by way of pre-encoding processing, for example *DPCM, motion estimation, spatial prediction.*

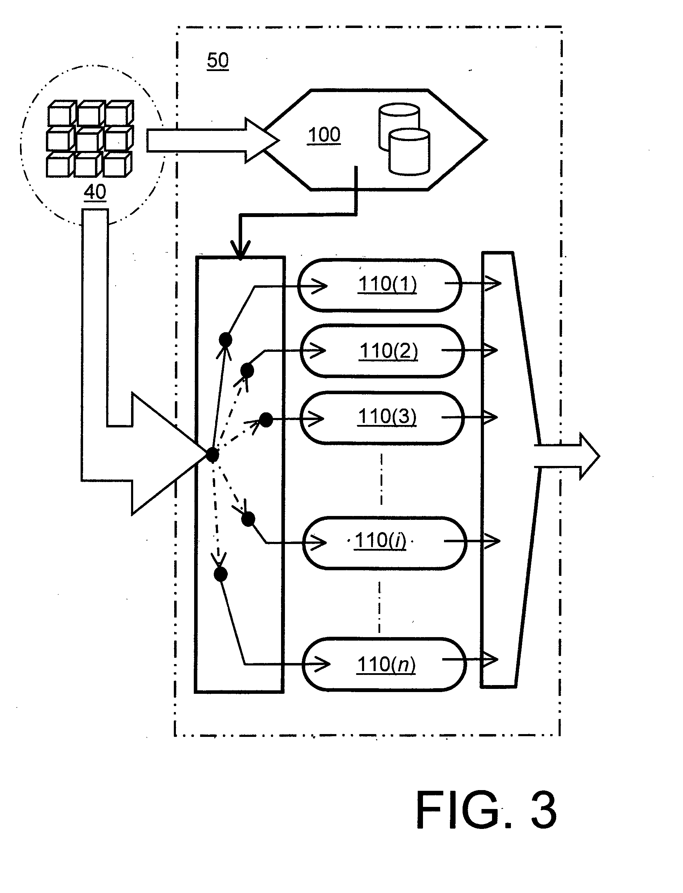

As aforementioned, in the second stage **50** of the encoder **10,** a compression method pursuant to the present disclosure is employed as illustrated in FIG. 3. Data blocks **40** from the first stage **30** are analyzed in an analysis unit **100** to determine a most appropriate encoding algorithm to employ for encoding the data blocks **40;** depending upon the analysis executed by the analysis unit **100,** the data blocks are directed to one or more encoding units **110(1)** to **110(*n*),** wherein n is an integer and describes a total number of different coding algorithms employed within the second stage **50;** the total number of different coding algorithms optionally includes a combination of known encoding algorithms, together with, for example, a two-level encoding algorithm pursuant to the present disclosure, wherein computed values associated with the two levels are, for example, determined from a mean or average computation applied to data values within a given data block **40** being encoded; it will be appreciated that a two-level encoding algorithm is merely an example, and that various multi-level algorithms are optionally employed. The analysis unit **100** analyses a number of different colours present in the data blocks **40** and spatial frequency information present in the data blocks **40** for purposes of deciding which encoding unit **110** is optimal to employ for encoding a given type of data block **40.** The encoding units **110** optionally employ one or more of: DC *("Direct Current"*) encoding, slide encoding, DCT *("discrete cosine transform"*), wavelet encoding, palette encoding, database encoding, VQ *("vector quantization"*) encoding, scale encoding, line encoding, interpolation and extrapolation methods. In encoded data from the second stage **50,** there is included data indicative of which of the encoder units 110 have been employed for any given data block **40.** At least one encoding unit **110(*i*)** of the encoding units **110,** wherein an integer i is in a range 1 to *n,* employs a coding algorithm pursuant to the present disclosure which will be described in more detail later. Optionally, sizes of the data blocks **40** can vary in a data stream provided from the first stage **30,** wherein information provided to the second stage **50** also includes information which is spatially indicative of where the data blocks **40** are included in any one or more given images; such information is included in the encoded data provided from the second stage **50;** such inclusion of the data-block position indicative data is beneficially implemented as described in United Kingdom patent application no. GB1214414.3 (encoder), which has related filings in US13/584005 & EP13002521.6, and United Kingdom patent application no. GB1214400.2 (decoder), which has related filings in US13/584,047 & EP13002520.8, these applications being hereby incorporated by reference, as well as corresponding related foreign patent applications are also hereby incorporated by reference. Alternatively, such inclusion is beneficially implemented in the third stage **60.** Sizes of the data-blocks can be presented with numbers such as *height x width* expressed in pixels. Spatial positions of the data-blocks are beneficially defined as co-ordinates relative to the image such as x, y pixels from a corner of the image. Optionally, the analysis unit **100** and the first stage **30** operate in an iterative manner to partition the data **20** (D1) to be encoded into the data blocks **40** in a manner which provides for most efficient data compression in one or more selected encoder unit **110(1)** to **110(n),** for example spatial positions and sizes of the data blocks **40** within the data 20 (D1) are selected, taking into account the different encoder units **110(1)** to **110(n)** available to the encoder **10.** Optionally, the encoder units **110(1)** to **110(n)** are implemented, at least in part, in software, and are upgradeable on a periodic bases to improve progressively encoding performance of the encoder **10,** for example for enabling the encoder **10** to adapt in a flexible manner to different types of data 20 (D1).

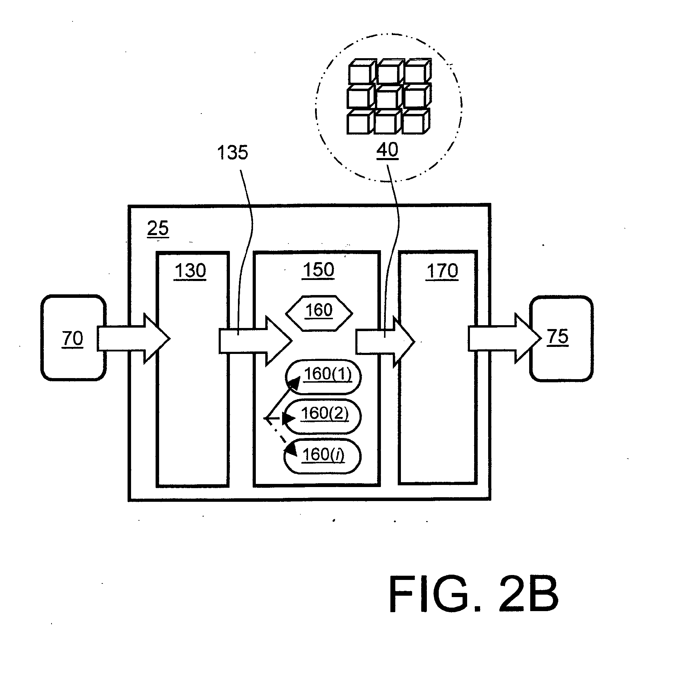

Referring to FIG. 2B, the decoder **25** corresponding to the encoder **10** is shown. The decoder **25** includes a first decoding stage **130** which is operable to receive the encoded data **70** and to execute upon the encoded data **70** an inverse of encoding applied by third stage **60** of the encoder **10** for generate intermediate decoded data denoted by **135.** The intermediate decoded data includes information such as which type of encoding unit **110** was employed to encode a given data block **40,** mask for the data block **40,** aggregate value where appropriate, and so forth; optionally, the aggregate value includes an average value, but is not limited thereto. The decoder **25** further includes a second stage **150** which includes one or more decoder units **160** corresponding to an inverse of the encoder units **110,** wherein the encoded data blocks present in the intermediate decoded data **135** are directed to appropriate decoder units **160** included in the second stage to regenerate the data blocks **40** within the decoder **25**. The decoder **25** further includes a third stage **170** which is operable to apply an inverse of operations performed in the first stage **30** of the encoder **10,** for generating the decoded data **75** corresponding substantially to the data **20** (D1) and/or the encoded data (E2). Additionally, or alternatively, spatial and size information of data blocks **40** are optionally generated in a first decoding stage **130**. The spatial and position information is beneficially further sent to the second stage **150** in order to enable the third stage **170** to place data blocks in appropriate spatial positions.

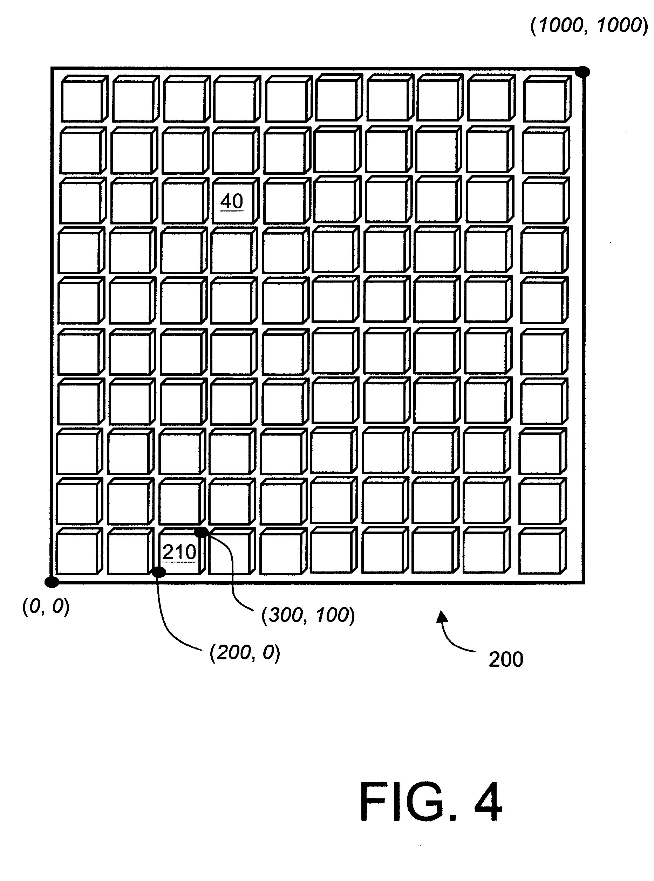

The encoding algorithm pursuant to the present invention is susceptible to being employed to encode data blocks **40** of any size, although it is beneficially employed for encoding data blocks **40** including in a range of 8 to 256 elements or values, for example pixels. Moreover, the coding algorithm is conveniently referred to as being a *multilevel coding method.* A first and most useful implementation of the algorithm employs two levels, for example colours although not limited thereto as aforementioned, and is optimized to encode subject matter such as code command prompts, text and other content that include only two levels. However, it is optionally feasible to implement the algorithm to encode more than two levels, for example three levels, four levels, or even more levels, namely "multilevel"; beneficially, the number of levels into which data blocks are encoded is beneficially considerably less than a number of levels present in the data blocks **40** prior to being encoded, for example beneficially at least 3 times less, more beneficially at least 5 times less, and yet more beneficially at least 10 times less. The number of levels present in the data blocks prior to being encoded in the second stage **50** is referred to as being the *original number of levels,* namely is a measure of dynamic levels present in the data blocks 40, for example representative of image-, video-, audio- or graphics-content. For example, referring to FIG. 4, an image field **200** includes 1000 x 1000 pixel points in a 2-dimensional array, wherein the image field **200** is subdivided in the first stage **30** of the encoder **10** into 100 data blocks **40,** denoted by **210,** wherein each block **210** corresponds to 100 x 100 pixels, namely 10, 000 pixels in total. Each pixel is represented in colour and/or intensity by 8 binary bits defining 256 levels of dynamic range. The dynamic range can also be limited, and then the number of levels can also be calculated by using the equation:

$$\text{number of levels} = \text{amplitude value} = \text{maximum level} - \text{minimum level} + 1.$$

The number of levels can also be described by using the number of different levels used in the data or in the data block, and then the value can be the same or smaller than the amplitude value. For the original number of levels, all different equations can be used, but the output number of levels typically addresses the number of different levels used in the data block. When the encoding unit **110($i$)** encodes a given block **210,** the number of levels is reduced, for example, in a range of 2 to 8, together with supplementary data as will be described later. In a event that the encoding unit **110($i$)** employs more than, for example, 8 levels, the encoding unit **110($i$)** becomes less efficient at providing data compression, requiring use of pre-processing of the image **200,** for example predictive coding or delta coding, prior to data being presented to the second stage **50.**

The encoding algorithm employed in the encoding unit **110($i$)** is optionally employed for encoding a greyscale image or other information that only uses one channel. Moreover, the encoding algorithm employed in the encoding unit **110($i$)** is optionally employed for colour images or other multichannel content. Multichannel content, for example 3-D colour images, are optionally encoded so that all the channels are compressed similarly, or alternatively are optionally encoded in mutually different manners, for example data blocks of audio channels are optionally encoded in a different manner to data blocks of video channels. In an event that the channels are encoded in a mutually different manner, different coding algorithms in the encoder units **110** and different sizes of the data blocks **40** can be employed; the selection of data block **40** sizes is, as aforementioned, optionally implemented on a basis of type of content present in the data 20 (D1) to be encoded.

The data block values produced by employing the multilevel method pursuant to the present disclosure are optionally transferred also to a database, so that they can be utilized by later, successive data blocks. The database can be generated separately at the encoder **10,** during encoding of the data **20** (D1), and optionally at the decoder **30,** during decoding of the encoded data **70** (E2). Alternatively, both the encoder **10** and the decoder **25** can use a common database which either of them generates, or which some other device or software application has generated, and which both of them can utilize similarly. In both cases, the databases that the encoder **10** and the decoder **25** use are beneficially identical, and thus the database reference that is transmitted always represents similar data values in all stages, namely in the calculation at the encoder **10,** in the reconstruction at the encoder **10,** and also in the reconstruction at the decoder **25**. With the data block values, or instead of the data block values, also the masks used in the multilevel method, can be transferred into the database. Both the masks and the data block values can be retrieved from the database to be used in coding content of future data blocks or the data blocks coded with the multilevel method pursuant to the present disclosure, thereby reducing the data size of the data to be stored and/or transmitted, and thereby further improving the compression ratio achievable in the codec arrangement **5.**

The multilevel method pursuant to the present disclosure can also be utilized, for example, to compress databases or individual database elements in the databases. The method is very well suited for both lossless and lossy compression. For many types of data present in the data **20** (D1) to be encoded, such as audio and image or video data, lossy compression is not only acceptable, but improves the achievable compression ratio significantly in respect of the encoded data **70** (E2). However, some other types of data such as databases, documents or binary data often, if not always, need to be compressed losslessly, and therefore, a need usually arises to use multiple levels in the multilevel method, or alternatively, smaller data blocks can be optionally used in the codec arrangement **5.**

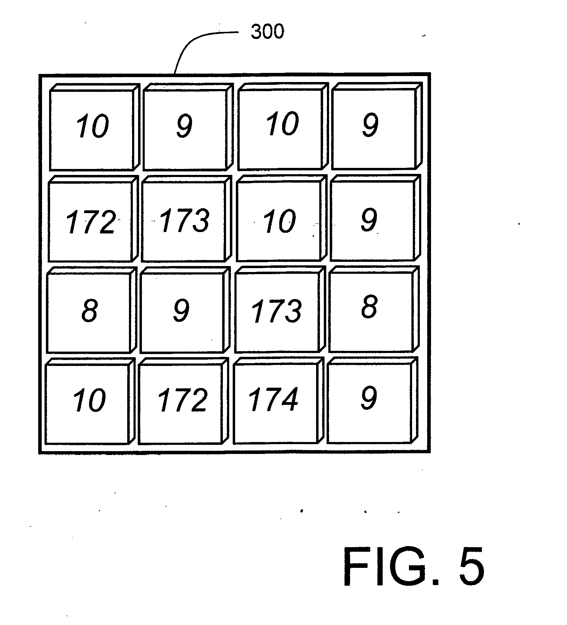

The encoding algorithm employed in the encoding unit **110(*i*)** will now be described in greater detail with reference to FIG. 5. In FIG. 5, an example original data block 40 is denoted by **300.** The data block **300** includes 4 x 4 pixels having greyscale values as shown. Beneficially, the data block **300** is susceptible to being encoded efficiently in the encoding unit **110(*i*)** using an algorithm pursuant to the present disclosure, with a small coding error occurring during encoding.

When applying the algorithm, a mean value for all pixels or elements in the block **300** is computed in computing hardware or dedicated digital hardware of the encoder **10** pursuant to Equation 1 (Eq. 1):

$$\mathrm{MeanAll} = \frac{(10+9+10+9+172+173+10+9+8+9+173+8+10+172+174+9)}{16} = \qquad \text{Eq. 1}$$

$$\frac{965}{16} = 60.3125$$

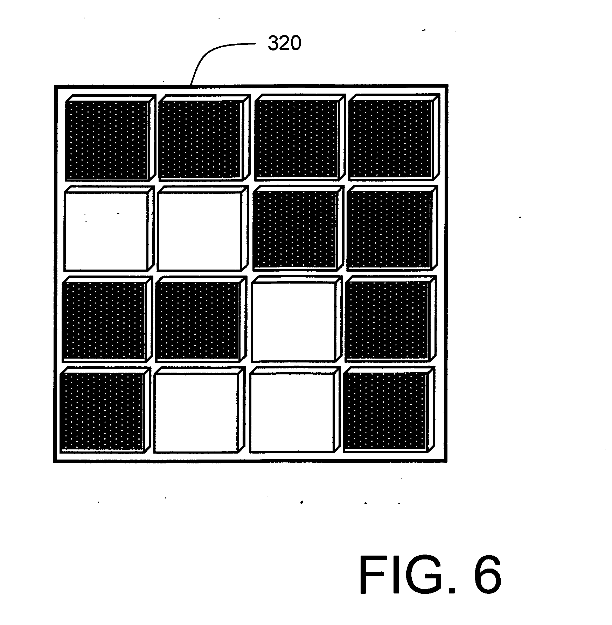

Next, the algorithm defines two sets of levels, namely Level_0 and Level_1, wherein the set Level_0 includes all pixels whose values are below MeanAll, and the set Level_1 includes all pixels whose values are equal to or above MeanAll. The pixels of the data block **300** are then mapped onto a corresponding data block **320** in FIG. 6, wherein spatial locations of the pixels are retained but they are now represented by merely two levels corresponding to the sets Level_0 and Level_1. For each of the sets of levels, namely Level_0 and Level_1, mean values, namely an example of aggregate values, are computed in the aforesaid computing hardware or dedicated digital hardware pursuant to Equation 2 (Eq. 2) and Equation 3 (Eq. 3):

$$\mathrm{MeanLevel\_0} = \frac{(10+9+10+9+10+9+8+9+8+10+9)}{11} = \frac{101}{11} = 9.1818... \quad \text{Eq. 2}$$

$$\mathrm{MeanLevel\_1} = \frac{(172+173+173+172+174)}{5} = \frac{864}{5} = 172.8 \qquad \text{Eq. 3}$$

Optionally, numbers summed within the brackets above are each multiplied by an associated coefficient when a spatial weighted mean level is to be calculated, wherein the associated coefficients can be mutually different. In an event that the encoder **10** and decoder **25** use these coefficients, and inverses thereof when appropriate, it is feasible to "watermark" data when encoded and compressed, for example to discourage unauthorized copying of data, wherein the decoder **25** is provided with the inverse coefficients, for example from a database, in return for payment, for example a regular subscription payment. This enables, for example, data content to be consumed by a given end user in a degraded quality free of cost, and consumed by the given end user in high quality in return for making a subscription payment, or similar type of payment.

Thereafter, referring to Equations 2 and 3 above (Eq. 2 and Eq. 3), when executing the algorithm, a spatial representation of the pixels in the data block **320** is stored as a pixel mask, together with mean values for each of the sets of levels, namely MeanLevel_0 and MeanLevel_1; alternatively, instead of storing in data memory, such data is streamed from the encoder unit **110(*i*)**. Although a geometric mean computation is described in the foregoing for the algorithm, it will be appreciated that other types of computation are possible, for example a skewed mean, an asymmetrical mean, a logarithmic mean, a minimum value, a maximum value, a modal value, a median value. Optionally, the values for each of the set of levels can be calculated using any calculating means, for example dedicated digital hardware and/or a computing device executing software products. From a point of view of the decoder, a method of calculation employed is not a key issue. Optional examples of computing means include "brute force" methods, Monte Carlo methods and so forth, to find optimum number of levels and values for the set of levels. Example optimization can be Rate-Distortion optimization to determine how many bits should be used during coding and how much error is allowed for the coded information. Instead of outputting from the algorithm, one mean value is optionally output from a reference of one of the sets, and a difference value for the other set relative to the reference set, for example 9.1818 and (172.8 - 9.1818). Optionally, the mean values as computed above are quantized, for example to nearest integer values, in order to obtain a higher degree of data compression in output data from the encoder unit **110(i).** Optionally, a degree of quantization employed is a dynamic function of how many sets are required to represent the data block **300.** Quantization to nearest integer for the example above provides MeanLevet_0 = 9, and MeanLevel_1 = 173.

When generating encoded data (E2) from the encoder unit **110(i),** a spatial representation of the pixels, namely a mask, is output, based upon the data block 320, in a plurality of potential scanning orders, for example left-to-right and top-to-bottom as illustrated in FIG. 6, in a zig-zag manner, maze or similar. In an example, the mask is output left-to-right and top-to-bottom such that mask is expressed in output data from the encoder unit **110(i)** as 0000 1100 0010 0110.

When the encoder **10** is employed to encode video content (D1), a sequence of images is presented to the encoder **10,** wherein each image is susceptible to being broken down into data blocks **40** which are then encoded using the encoder units **110** as appropriate depending upon their content. Beneficially, as aforementioned, the encoder **10** switches dynamically between the different encoder units **110** depending upon a nature of data blocks presented to the second stage **50** for encoding. The choice of encoder units **110** is, as aforementioned, recorded in the encoded data from the second stage **50.** The third stage **60** optionally applies further encoding and/or compression, for example using one or more of DPCM (*"differential pulse-code modulation"*), RLE (*"run-length encoding"*), SRLE, EM (Entropy Modifier), arithmetic coding, delta coding, ODelta coding, VLC *("Variable-length coding"*), Lempel-Ziv coding methods (such as ZLIB, LZO, LZSS, LZ77), Burrow-Wheeler transform based coding methods (such as RLE, BZIP2) and Huffman coding. Delivery of the mask, namely scanning order for data output from the second stage **50,** is beneficially implemented via a database, for example as described in a United States patent application no. US2010/0322301 ("*Image processor, image generator and computer program",* Applicant - Gurulogic Microsystems Oy, Inventor - Tuomas Kärkkäinen) which is hereby incorporated by reference. Use of such a database for providing a path by which the mask is communicated to a corresponding decoder is capable of providing a form of access key, for example for hindering unauthorized distribution of encoded content in encoded form (i.e. unauthorized file sharing).

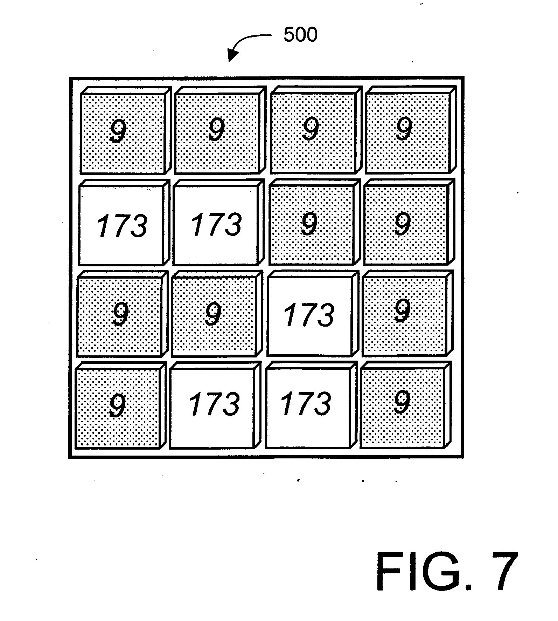

A regenerated decoded version of the data block **300** of FIG. 5 is illustrated in FIG. 7 and indicated by **500.** This regenerated data block **500** corresponds to a portion of the decoded output data **75** provided from the decoder **25.** It will be appreciated that only minor loss of information present in the data block **500** occurs relative to the original data block **40, 300** which is input to the encoder **10.**

Another example has seventeen samples of measurement data that can also be encoded efficiently by using a multilevel method of the present disclosure. The original sample values are as follows:

**122, 153, 190, 198, 188, 156, 153, 119, 148, 122, 122, 153, 196, 120, 198, 152, 154**

The mean value (= 155.53) can be used to divide these values to two groups, but this is not the best solution for coding the data. Two groups then contain values as follows:

**low = 122, 153, 153, 119, 148, 122, 122, 153, 120, 152, 154     (Mean = 138)**
**high = 190, 198, 188, 156, 196, 198                              (Mean = 187.66)**

These two levels with mean values as aggregate values (138 and 188) would lead to a high reconstruction error (sum of absolute differences (SAD) = 230).

A better division point can be found, for example, by using an equation as follows:

$$\textbf{(Min + Max) / 2 = (119 + 198) / 2 = 158,5,}$$

and then those two groups contain the following values:

**low = 122, 153, 156, 153, 119, 148, 122, 122, 153, 120, 152, 154     (Mean = 139,5)**
**high = 190, 198, 188, 196, 198                                        (Mean = 194)**

These two levels with values 140 and 194 would lead to a lower error (SAD = 204).

Similar division to two level groups (low and high) can also be computed in several other ways. One beneficial solution for the level group division is the solution that divides the data to new level groups when a change in the data is high, or highest. Such a highest change can be found easily when the data is first ordered from an associated lowest value to an associated highest value. The ordered data values are as follows:

**119, 120, 122, 122, 122, 148,152, 153, 153, 153, 154, 156, 188, 190, 196, 198, 198,**

and the highest change in data is between the values 188 and 156 (= 32).

With two levels, the reconstruction error is still quite high, and a similar division rule can be continued for the group where the change in data is highest. In this case, the second division point can be found between the values 148 and 122 (= 26). Now, the level groups are as follows:

**group(0) = 119, 120, 122, 122, 122         (Mean = 121)**
**group(1) = 148, 152, 153, 153, 153, 154, 156   (Mean = 152.71)**
**group(2) = 188, 190, 196, 198, 198          (Mean = 194)**

Now, with these three levels and aggregate values 121, 153, and 194, the SAD is only (6 + 10 + 20 =) 36.

It is also possible to use model values as aggregate values for these three levels, and then the aggregate values are as follows: 122, 153, and 198. Now, the SAD is (5 + 10 + 20 =) 35.

Using the median as aggregate value would create the values 122, 153, and 196. The SAD is now (5 + 10 + 18 =) 33. The aggregate value can always be selected freely, and different aggregate values for different groups can be used to create a best reconstruction, depending on selected error criteria.

If the SAD value 33 is not good enough, then it is possible to create even more levels (for example 4 to 12 levels), or the reconstruction error (namely delta values) can be encoded by using some coding method, for example VLC.

If the SAD value 33 is good enough, then these three aggregate level values (122, 153, and 196) are used within a mask that describes which data values belong to which levels. Now, because the level 1 has the most values, those mask values are set to "0", level 0 values are set to "10" and level 2 values are set to "11". So, the mask values can be presented as follows:

**10, 0, 11, 11, 11, 0, 0, 10, 0, 10, 10, 0, 11, 10, 11, 0, 0**

It is also possible to use two sets of binary masks to describe the mask that specifies the data for different levels. For example, the first binary mask specifies the first division for low values (<= 156) as "0" and high values (>= 188) as "1":

**0, 0, 1, 1, 1, 0, 0, 0, 0, 0, 0, 0, 1, 0, 1, 0, 0,**

and the second binary mask specifies the second division of low values for group(0) (<= 122) as "0" and group(1) (>= 148) as "1":

**0, 1, 1, 1, 0, 1, 0, 0, 1, 0, 1, 1.**

All the example masks and level values can be further compressed with a multiplicity of methods such as delta, RLE, VLC, database, and so forth.

The encoder **10** and/or or decoder **25** are beneficially implemented using dedicated electronic hardware, for example a custom digital integrated circuit, a field-programmable gate array *(FPGA)* or similar. Alternatively, or additionally, the encoder **10** and/or the decoder **25** can be implemented by executing one or more software products, stored on non-transitory machine-readable data storage media, on computing hardware coupled in data communication with data memory. Optionally, the computing hardware is implemented as a high-speed reduced-instruction-set (RISC) processor. The encoded data **70** (E2) is optionally one or more of: streamed, stored on a data carrier such as an optically-readable disc, stored in data memory and so forth.

Modifications to embodiments described in the foregoing are possible without departing from the scope of the invention as defined by the accompanying claims. Expressions such as "including", "comprising", "incorporating", "consisting of", "have", "is" used to describe and claim the present invention are intended to be construed in a non-exclusive manner, namely allowing for items, components or elements not explicitly described also to be present. Reference to the singular is also to be construed to relate to the plural. Numerals included within parentheses in the accompanying claims are intended to assist understanding of the claims and should not be construed in any way to limit subject matter claimed by these claims.

**Claims**

1. An encoder (10) for encoding data (20, D1) to generate corresponding encoded data (70, E2), **characterized in that** the encoder (10) includes
an analysis unit (100) for analysing one or more portions (40) of the data (20, D1) to be encoded, and directing the one or more portions (40) to appropriate one or more encoding units (110), wherein the one or more encoding units (110) are operable to encode the one or more portions (40) thereat to generate the encoded data (70, E2), wherein:

   the one or more encoding units (110) are operable to employ mutually different encoding algorithms when encoding the one or more portions (40);
   at least one encoding unit (110($i$)) of the one or more encoding units (110) is operable to compute data values present in each portion (40) received thereat, to subdivide the data values into at least two sets, to compute at least one aggregate value for a given set derived from the data values present in the given set, and whilst retaining a spatial mask (320) of the portion (40), and wherein the spatial mask (320) and information representative of the values computed for the at least two data sets are included in the encoded data (70, E2).

2. An encoder (10) as claimed in claim 1, **characterized in that** the encoder (10) includes an output encoder unit (60) for receiving encoded output data from the one or more encoding units (110) and for further encoding this encoded output data to generate the total encoded data (70, E2) from the encoder (10).

3. An encoder (10) as claimed in claim 1 or 2, **characterized in that** the encoder (10) further includes an input stage (30) for sub-dividing and/or combining the data (20, D1) to be encoded to generate the one or more portions (40) when the data (20, D1) to be encoded is not already included in the one or more portions (40).

4. An encoder (10) as claimed in any one of the preceding claims, **characterized in that** the encoder (10) is operable to store information representative of the one or more masks (320) of the one or more portions in a remote database for access by one or more decoders when decoding the encoded data (70, E2) generated by the encoder (10).

5. An encoder (10) as claimed in any one of the preceding claims, **characterized in that** the at least one aggregate value is an arithmetic average, a skewed average, a logarithmic average, a weighted average, a mean value, a minimum value, a maximum value, a modal value, or a median value.

6. A method of encoding data (20, D1) to generate corresponding encoded data (70, E2), **characterized in that** the method includes:

   (a) using an analysis unit (100) for analysing one or more portions (40) of the data (20, D1) to be encoded, and directing the one or more portions (40) to appropriate one or more encoding units (110), wherein the one or more encoding units (110) are operable to encode the one or more portions (40) thereat to generate the encoded data (70, E2), wherein the one or more encoding units (110) are operable to employ mutually different encoding algorithms when encoding the one or more portions (40); and
   (b) using at least one encoding unit (110($i$)) of the one or more encoding units (110) to compute data values present in each portion (40) received thereat, to sub-divide the data values into at least two sets, to compute at least one aggregate value for a given set derived from the data values present in the given set, and whilst retaining a spatial mask (320) of the portion (40), wherein the spatial mask (320) and information representative of the values computed for the at least two data sets are included in the encoded data (70, E2).

7. A method as claimed in claim 6, **characterized in that** the method includes using an output encoder unit (60) for receiving encoded output data from the one or more encoding units (110) and for further encoding this encoded output data to generate the total encoded data (70, E2).

8. A method as claimed in claim 6 or 7, **characterized in that** the method includes storing information representative the one or more masks (320) of the one or more portions in a remote database for access by one or more decoders when decoding the encoded data (70, E2).

9. A method as claimed in any one of claims 6 to 8, **characterized in that** the encoded data (70, E2) is further encoded and/or compressed.

10. A method as claimed in claim 9, **characterized in that** the further encoding and/or compression includes at least one of: DPCM (*"differential pulse-code modulation"*), RLE (*"run-length encoding"*), SRLE, EM (Entropy Modifier), arithmetic encoding, delta coding, ODelta coding, VLC ("*Variable-Length Coding*"), Lempel-Ziv coding (ZLIB, LZO, LZSS, LZ77), Burrow-Wheeler transform-based coding (RLE, BZIP2), Huffman coding.

11. A decoder (25) for decoding encoded data (70, E2) to generate corresponding decoded data (75, D3), **characterized in that** the decoder (25) includes an analysis unit (130) for analysing one or more portions (40) of the encoded data (70, E2) and directing the one or more portions (40) to appropriate one or more decoding units (160), wherein the one or more decoding units (160) are operable to decode the one or more portions (40) threat for generating the decoded data (75, D3), wherein
at least one decoding unit (160(*i*)) of the one or more decoding units (160) is operable to extract a spatial mask (320) and information representative of aggregate values for at least two data sets included in the encoded data (70, E2), and for assigning values to elements in the mask (320) pursuant to which of the sets the elements belong as defined by the mask (320).

12. A decoder (25) as claimed in claim 11, **characterized in that** the decoder (25) includes an output decoder unit (170) for receiving decoded output data from the one or more decoding units (160) and for further combining these decoded output data to generate the total decoded data (75, D3) from the decoder (25).

13. A decoder (25) as claimed in claim 11 or 12, **characterized in that** the decoder (25) further includes an input stage (130) for extracting from the encoded data (70, E2) one or more portions for directing as defined by encoding parameters present in the encoded data (70, E2) to one or more decoding units (160).

14. A decoder (25) as claimed in any one of claims 11 to 13, **characterized in that** the decoder (25) is operable to retrieve information representative the one or more masks (320) of the one or more portions from a remote database when decoding the encoded data (70, E2) generated by an encoder (10).

15. A method of decoding encoded data (70, E2) to generate corresponding decoded data (75, D3), **characterized in that** the method includes:

(a) using an analysis unit (130) for analysing one or more portions (40) of the encoded data (70, E2) and directing the one or more portions (40) to appropriate one or more decoding units (160), wherein the one or more decoding units (160) are operable to decode the one or more portions (40) threat for generating the decoded data (75, D3); and
(b) using at least one decoding unit (160(*i*)) of the one or more decoding units (160) to extract a spatial mask (320) and information representative of aggregate values computed for at least two data sets included in the encoded data (70, E2), and to assign values to elements in the mask (320) pursuant to which of the sets the elements belong as defined by the mask (320).

16. A method as claimed in claim 15, **characterized in that** the method includes using an output decoder unit (170) for receiving decoded output data from the one or more decoding units (160) and for further combining these decoded output data to generate the total decoded data (75, D3).

17. A method as claimed in claim 15 or 16, **characterized in that** the method further includes using an input stage (130) for extracting from the encoded data (70, E2) one or more portions for directing as defined by encoding parameters present in the encoded data (70, E2) to one or more decoding units (160).

18. A method as claimed in any one of claims 15 to 17, **characterized in that** the at least one decoding unit (160(*i*)) of the one or more decoding units (160) is operable to assign values to elements of the mask (320) corresponding the data sets, wherein there are in a range of 2 to 8 data sets, or 2 or more data sets.

19. A method as claimed in any one of claims 15 to 18, **characterized in that** the method includes retrieving information representative the one or more masks (320) of the one or more portions from a remote database when decoding the encoded data (70, E2) generated by an encoder (10).

**20.** A data communication system (5) including at least one encoder (10) as claimed in claim 1 for encoding data (20, D1) and generating corresponding encoded data (70, E2), and including at least one decoder (25) as claimed in claim 13 for decoding the encoded data (70, E2) to generate decoded data (75, D3).

**21.** A method of communicating data in a data communication system (5) as claimed in claim 23, wherein the method of communicating data utilizes a combination of a method as claimed in claim 7, and a method as claimed in claim 18.

**22.** A software product recorded on non-transitory machine-readable data storage media, **characterized in that** the software product is executable upon computing hardware for executing a method as claimed in any one of claims 7 to 12, or 18 to 22.

FIG. 1

FIG. 2A

FIG. 2B

50

40

100

110(1)

110(2)

110(3)

110(i)

110(n)

# FIG. 3

*(1000, 1000)*

*(0, 0)*

*(300, 100)*

*(200, 0)*

200

# FIG. 4

300

| 10 | 9 | 10 | 9 |
| 172 | 173 | 10 | 9 |
| 8 | 9 | 173 | 8 |
| 10 | 172 | 174 | 9 |

# FIG. 5

320

FIG. 6

500

FIG. 7

Europäisches
Patentamt

European
Patent Office

Office européen
des brevets

# EUROPEAN SEARCH REPORT

Application Number

EP 13 00 3859

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | FRANTI P ET AL: "COMPRESSION OF DIGITAL IMAGES BY BLOCK TRUNCATION CODING: A SURVEY", COMPUTER JOURNAL, OXFORD UNIVERSITY PRESS, vol. 37, no. 4, 1 January 1994 (1994-01-01), pages 308-332, XP000483713, ISSN: 0010-4620, DOI: 10.1093/COMJNL/37.4.308 * the whole document * | 1-22 | INV. H04N7/26 |
| X | US 6 567 559 B1 (EASWAR VENKAT V [US]) 20 May 2003 (2003-05-20) * column 2, lines 10-40 * * column 3, line 26 - column 6, line 34 * * column 7, line 4 - column 8, line 14 * | 1-22 | |
| X | CUILING LAN ET AL: "Compress compound images in H.264/MPEG-4 AVC by fully exploiting spatial correlation", IEEE INTERNATIONAL SYMPOSIUM ON CIRCUITS AND SYSTEMS, ISCAS 2009, 24 May 2009 (2009-05-24), pages 2818-2821, XP031479830, ISBN: 978-1-4244-3827-3 * the whole document * | 1-22 | TECHNICAL FIELDS SEARCHED (IPC)<br><br>H04N |

The present search report has been drawn up for all claims

| Place of search | Date of completion of the search | Examiner |
|---|---|---|
| The Hague | 17 January 2014 | André, Thomas |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

 

& : member of the same patent family, corresponding
　　document

EPO FORM 1503 03.82 (P04C01)

**ANNEX TO THE EUROPEAN SEARCH REPORT
ON EUROPEAN PATENT APPLICATION NO.**                    EP 13 00 3859

This annex lists the patent family members relating to the patent documents cited in the above-mentioned European search report.
The members are as contained in the European Patent Office EDP file on
The European Patent Office is in no way liable for these particulars which are merely given for the purpose of information.

17-01-2014

| Patent document cited in search report | Publication date | Patent family member(s) | Publication date |
|---|---|---|---|
| US 6567559 B1 | 20-05-2003 | NONE | |

EPO FORM P0459

For more details about this annex : see Official Journal of the European Patent Office, No. 12/82

**EP 2 723 071 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6151409 A
- US 5668932 A
- WO 0019374 A
- GB 1214414 A
- US 13584005 B
- EP 13002521 A
- GB 1214400 A
- US 13584047 B
- EP 13002520 A
- US 20100322301 A

### Non-patent literature cited in the description

- *Proceedings of the 2008 IAJC-IJME International Conference, International Journal of Modern Engineering,* 2008
- *IEEE Transactions on Geoscience and Remote Sensing,* May 1993, vol. 31 (3), 645-654
- *IEEE Transactions on Acoustics, Speech and Signal Processing,* May 1989, vol. 37 (5), 778-780